# FASCICULE DE BREVET EUROPEEN

(11) **EP 2 272 083 B1**
(45) Date de publication et mention de la délivrance du brevet: **23.03.2016**
(21) Numéro de dépôt: 09745956.4
(22) Date de dépôt: 16.04.2009
(51) Int. Cl.: H01L 21/67, H01L 21/673

(54) **STATION ET PROCEDE DE MESURE DE LA CONTAMINATION D'UNE ENCEINTE DE TRANSPORT DE SUBSTRATS SEMI-CONDUCTEURS**
STATION UND VERFAHREN ZUR MESSUNG DER VERSCHMUTZUNG EINES BEHÄLTNISSES FÜR DEN TRANSPORT VON HALBLEITERSUBSTRATEN
STATION AND METHOD FOR MEASURING THE CONTAMINATION OF AN ENCLOSURE USED FOR TRANSPORTING SEMICONDUCTOR SUBSTRATES

(30) Priorité: 24.04.2008 FR 0802284
(43) Date de publication de la demande: 12.01.2011
(73) Titulaire: Pfeiffer Vacuum, 74000 Annecy (FR)
(72) Inventeur: FAVRE, Arnaud, F-74009 Annecy (FR); GODOT, Erwan, F-74009 Annecy (FR); BELLET, Bertrand, F-73000 Chambery (FR)
(74) Mandataire: Croonenbroek, Thomas Jakob
(86) Numéro de dépôt international: PCT/FR2009/050713
(87) Numéro de publication internationale: WO 2009/138637

(56) Documents cités:
- JP-A- 64 001 228
- US-A1- 2002 029 791
- US-A1- 2007 062 561
- US-B1- 6 202 318

## Description

La présente invention concerne une station de mesure de la contamination en particules d'une enceinte de transport pour le convoyage et le stockage atmosphérique de substrats semi-conducteurs tels que des plaquettes semi-conductrices (« wafers » en anglais) ou des photomasques. L'invention concerne également un procédé de mesure correspondant.

Les enceintes de transport et de stockge déterminent un espace confiné sous pression atmosphérique, séparé de l'environnement d'utilisation et de transport du substrat, pour le transport et le stockage d'un ou de plusieurs substrats.

Dans l'industrie de fabrication de semi-conducteurs, ces enceintes permettent de transporter les substrats d'un équipement à l'autre ou de stocker les substrats entre deux étapes de fabrication.

On distingue notamment les enceintes standardisées de transports et de stockage de plaquettes à ouverture latérale de type FOUP (« Front Opering Unified Pod » en anglais) ou FOSB (« Front Opering Shipping Box » en anglais), ou à ouverture par le fond de SMIF Pod (« Standard Mechanical Interface Pod » en anglais), ou encore enceintes standardisées de transport et de stockage de photomasques de type RSP (« Reticle SMIF Pod » en anglais) ou MRP (« Multiple Reticule SMIF Pod »).

Ces enceintes de transport sont formées de matériaux tels que le polycarbonate, qui peuvent dans certains cas, concentrer les contaminants et en particulier des contaminants organiques aminés ou acides.

En effet, au cours de la fabrication des semi-conducteurs, les enceintes de transport sont manipulées, ce qui conduit à la formation de particules polluantes qui se longent dans les parois des enceintes de transport et les contaminent.

Les particules collées sur les parois des enceintes de transport peuvent ensuite se décoller, retomber sur les substrats stockés dans ces enceintes et les détériorer

Ces contaminations peuvent être très néfastes pour les substrats. Il est donc nécessaire de nettoyer régulièrement ces enceintes afin de pouvoir prendre rapidement des mesures de décontamination qui s'imposent.

On prévoit donc le nettoyage régulier de ces enceintes par leur lavage avec un liquide tel que de l'eau pure. Ces étapes de nettoyage sont réalisées soit directement dans les usines de fabrication de substrat semi-conducteur, soit dans des entreprises spécialisées dans le nettoyage d'enceintes de transport atmosphérique.

Pour déterminer lorsqu'une enceinte nécessite un nettoyage, un exemple de mesure de la contamination est décrit dans le document US2007/0062561.

On connaît aussi un procédé de mesure de la contamination en particules consistant à mesurer le nombre de particules déposées sur les parois des enceintes de transport à l'aide d'un détecteur de particules liquide. Ce procédé présente toutefois l'inconvénient d'être longs et lourd à implémenter dans un processus industriel de fabrication de semi-conducteur.

De plus, ce type de procédé n'est pas reproductible. En effet, la mesure obtenue est directement liée à l'entreprise spécialisée ayant été chargée de réaliser la mesure, ce qui ne permet pas la mise en place de contrôles standardisés.

Les industriels préfèrent donc envoyer régulièrement les enceintes de transport au nettoyage.

Par conséquent, certaines enceintes de transport exemptes de particules sont tout de même nettoyées, réduisant ainsi inutilement les cadences de fabrication, tandis que d'autres, polluées de particules, continuent à stocker et/ou transporter des substrats de semi-conducteurs avec des risques potentiels de contamination des substrats.

Les industriels prévoient donc de fréquents nettoyages préventifs de manière à ne pas impacter le niveau de défectivité des substrats.

Le but de la présente invention est donc de proposer une station de mesure et un procédé de mesure correspondant, permettant de mesurer un niveau de contamination en particules d'enceintes de transport pour le convoyage et le stockage atmosphérique de substrats semi-conducteurs, par une mesure réalisée en temps réel, pouvant être implémentée dans une chaîne de processus industriel de fabrication directement dans l'usine de fabrication.

A cet effet, l'invention a pour objet une station de mesure de la contamination en particules d'une enceinte de transport pour le convoyage et le stockage atmosphérique de substrats semi-conducteurs, telle que définie par la revendication 1.

Selon d'autres caractéristiques de la station de mesure, prises seules ou en combinaison,
- lesdites entretoises présentent la forme de plots,
- la station de mesure comporte une chambre atmosphérique de type salle blanche, de préférence certifiée Iso 3, entourant ladite interface,
- la buse d'injection est configurée pour injecter un jet de gaz pulsé,
- l'interface comporte une pluralité de buses d'injection pourvues de filtres à particules,
- la station de mesure comporte des obturateurs destinés à obturer des passages de gaz filtrés de l'enveloppe de l'enceinte de transport,
- la station de mesure comporte une unité de traitement pour transmettre un signal représentatif d'un état de propreté de l'enveloppe de ladite enceinte à une unité de nettoyage.

L'invention a aussi pour objet un procédé de mesure de la contamination en particules d'une enceinte de transport pour le convoyage et le stockage atmosphérique de substrats semi-conducteurs, tel que décrit dans la revendication 8.

On peut injecter un jet de gaz de façon discontinue, au cours de la première étape dudit procédé de mesure.

D'autres avantages et caractéristiques apparaîtront à la lecture de la description de l'invention, ainsi que des dessins annexés sur lesquels:
- la figure 1 est une vue schématisèe d'une station de mesure dans une position accouplée à une enveloppe d'une enceinte de transport,
- la figure 2 représente une variante de la station de mesure de la figure 1,
- les figures 3 et 4 sont des vues schématiques d'éléments d'une station de mesure accouplée à une enveloppe d'enceinte en cours de fonctionnement
- la figure 5 est un organigramme d'un procédé de mesure.

Par souci de clarté, les étapes du Procédé de mesure sont numérotées à partir de 100.

L'invention concerne une station de mesure de la contamination en particules d'une enveloppé d'enceinte de transport pour le convoyage et le stockage atmosphérique de substrats semi-conducteurs.

La station de mesure est susceptible de s'accoupler notamment avec au moins une enceinte de transport normalisée de type SMIF, FOUR, FOSB, RSP ou MRP,

Ces enseintes de transport et/ou de stockage et leur atmosphère intérieure sont à pression atmosphérique d'air ou d'azote. La pression atmosphérique est la pression qu'ont les enceintes de transport dans leur environnement d'utilisation, telle que la pression atmosphérique de la salle blanche.

Les enceintes de transport conportent une enveloppe périphérique pouvant être obturée par une porte d'accés amovible deminsionnée pour l'introduction et l'extraction de substrats

A l'intérieur de l'enveloppe, les enceintes de de transport sont munies d'un support de substrats, pour le maintien et le support d'un ou d'une pluralité de substrats.

L'enceinte est assez étanche mais le niveau d'étanchéité est tel que de légères fuites peuvent se produire à travers un joint d'étanchéité entre l'enveloppe et la porte.

Certaines enceintes de transport, notamment les enceintes de type FOUP, comportent des passages de gaz filtrés pour équilibrer la pression entre l'intérieur et l'extérieur de l'enceinte de transport.

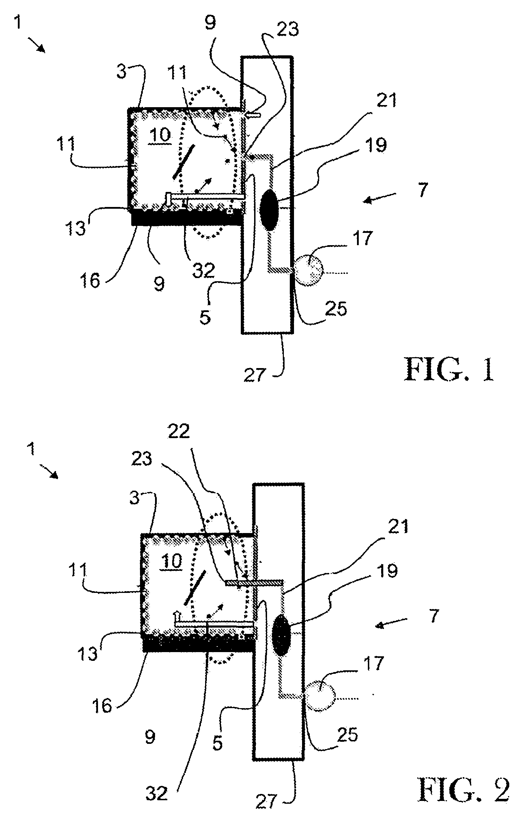

On a représenté sur la figure 1, une station de mesure 1 accouplée à une enveloppe d'enceinte de transport 3 pour le convoyage et le stockage atmosphérique de substrats semi-conducteurs de type FOUP.

La station de mesure est par exemple placée en salle blanche pour former un poste de contrôle.

la station de mesure peut également être intégrée dans un équipement de fabrication semiconducteur. L'équipemement de fabrication comporte alors de préférence, trois chambres de type salle blanche certifiée Iso 3 conformement à la norme ISO 14644-1 définissant la classification de la propreté de l'air des salles propres et environnement maîtrisés en termes de concentration des particules en suspension dans l'air.

Une première chambre est destinée à ôter la porte d'accès d'une enceinte de transport une deuxième chambre forme la station de mesure pour mesurer la contamination en particules de l'enveloppe 3 et une troisième chambre est par exemple une unité de nettoyage permettant de mettre en oeuvre un procédé de netoyage par un liquide.

La deuxieme chambre est en communication avec la première et la troisième chambre afin de pouvoir transférer l'enveloppe de l'enceinte de transport 3 d'une chambre à l'autre.

La station de mesure 1 comporte d'une part, une interface 5 susceptible de s'accoupler à l'enveloppe de l'enceinte de transport 3 et l'aurtre part un despositif de mesure 7.

L'interface 5 présente les mêmes dimensions qu'une porte d'accès d'enceinte de transport et peut anisi facilement être accouplée à une enveloppe d'enceinte de transport 3 à la place de la porte d'accès.

Bien que representée à la verticale sur la figure 1, l'interface 5 peut également être déposée dans n'importe quelle position, notamment en position horizontale.

L'interface 5 comporte en outre au moins une buse d'injection 9 pour diriger un jet de gaz dans une derection perpendiculaire à une portion de paroi 13 à l'intérieur 10 de l'inveloppe de l'enceinte 3 accouplée à la station de mesure 1, de manière à détacher des particules 11 de l'envelope 3 par l'impact du jet de gaz sur la paroi 13.

Le gaz est un gaz propre, par exemple de l'air ou d'azote.

Lors de l'injection ciblée du jet de gaz, le flux de gaz presente une faible disposition angulaire et génère durant quelques secondes, une force aérodynamique qui décroche les particules adhérées, aux parois internes 13 de l'enveloppe 3.

Pour améliorer le décrochage des particules, on injecte un flux non constant de gaz c'est-à-dire un jet de gaz pulsé, un jet de gaz mobile pouvant balayer une position de paroi 13, un jet de gaz successivement injecté à travers une pluralité de buses d'injection 9 on encore un flux de gaz modulé en amplitude, tel qu'une rampe de flux de gaz.

Ainsi, le jet de gaz attaque les parois 13 de façon discontinue, augmenntant le nombre de phases d'accéléfation du gaz, au cours desquelles les particules 11 sont décollées, favorisant la mesure du niveau de pollution en améliorant nettement le décrochage des parricules.

le dispositif de mesure 7 comporte une pompe à vide 17, un compteur de particules 19 et une canalisation de mesure 21 dont une entrée est susceptible d'être en mise en communication avec l'intérieur 10 de l'enveloppe 3 accouplée et dont une sortie, 25 est raccordée à la pompe à vide 17.

De préférence, l'entrée 23 débouche directement dans une face frontale de l'interface 5 (figure 1) ou peut être disposée plus à Intérieur 10 de l'enveloppe de transport 3 par un prolongement 22 de la canalisation de mesure 21 au-delà de l'interface 5 (figure 2).

La canalisation de mesure 21 est en outre raccordée au compteur de particules 19, pour mettre en communication l'intérieur 10 de l'enveloppe d'enceinte de transport 3 accouplée à la station de mesure 1 avec de compteur de particules 19.

Le compteur de particules 19 est de type aérosol, c'est-à-dire qu'il permet de donner une information quantitative des particules 11 en suspension dans un environnement gazeux. Par exemple le compteur à particules est basé sur la téchnologie laser.

De préférence, le flux de pompage de la pompe à vide 17 est de l'ordre de 1,7 m³/h.

L'entrainement des gaz produit par les buses 9 s'ajoute à celui créé par la pompe à vide 17, ce qui petmet d'amplifier la force de l'écoulement des gaz comportant les particules décollées 11, en direction de l'entrée 23.

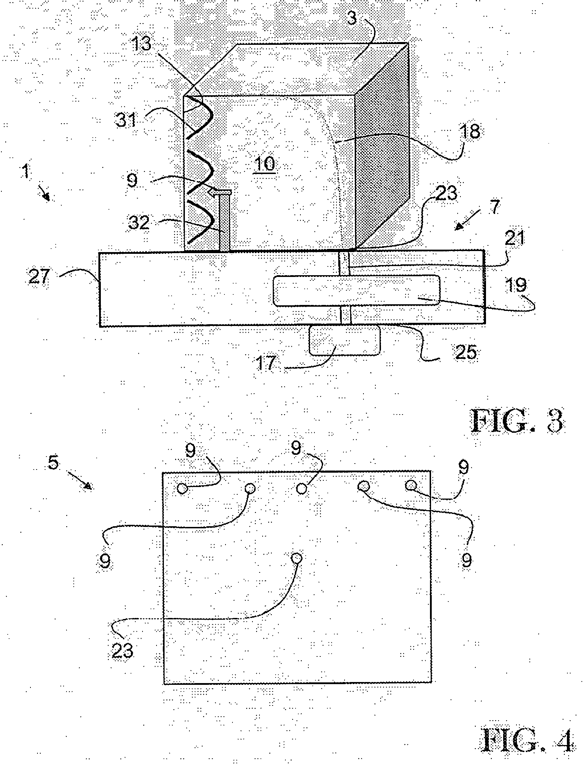

On a représenté un exemple de la trajectoire 18 de l'écoulement des gaz sur la figure 3. Cet écoulement de gaz 18 provoqué par le flux de pompage permet d'une part de collecter les particules 11 décollées en suspension et d'autre part de les diriger vers l'entrée 23 du dispositif mesure 7.

Ainsi, une majorité de particules décollées 11 de l'enveloppe 3 est potentiellement détectable par le compteur de particules 19

Par ailleurs, la station de mesure 1 comporte avantageusement une unité de traitement (non représentée) pour transmettre un signal représentatif d'un état de propreté de l'enveloppe de ladite enceinte 3 à une unité de nettoyage.

Comme visible en figure 2, la buse d'injection 9 est disposée à une extrémité mobile d'un tuyau saillant 32 de l'interface 5.

L'estrémité du tuyau 32 peut en outre être orientée vers l'interieur 10 de l'enveloppe 3. Ainsi le jet de gaz est également susceptible d'ateindre un support de substrat fixé à l'intérieur de l'inveloppe de l'enceinte de transport 3.

Avantageusement , la buse l'injection de gaz 9 est configurée pour injecter un jet de gaz pulsé. On règle alors la fréquance et la force de pulsation du jet de gaz 9 associé à une vitesse de pompage de la pompe à vide 17 adaptée de manière à générer une onde d'écoulement des gaz 31 dans l'enveloppe 3 permettant d'optimiser le décollement des particules 11.

La mobilité en translation et/ou en rotation de l'extrémité du tuyau 32 permet d'adapter la vitesse d'attaque du jet de gaz aux parois internes 13 et notamment, d'adapter la composante perpendiculaire de la vitesse du jet de gaz de manière à optimiser l'impacte provoquant le décollement des particules 11,

L'entrée 23 de la canalisation de mesure 21 est alors avantageusement disposée dans un prolongement 22 de la canalisation de mesure 21, de préférence également mobile en translation et/ou en rotation.

Ainsi, l'entrée 23 peut être placée à une distance et un angle constants par rapport à la buse d'injection 9, permettant d'obtenir une mesure indépendante de l'orientation de la buse d'injection 9.

La canalisation de mesure 21 et le tuyau 52 sont avantageusement disposés sur un même bras mobile (non représenté).

selon un deuxième mode de réalisation représente par la figure 4, l'interface 5 comporte une pluralité de buses d'injection de gaz 9.

l'injection discontinue est alors obtenue par l'injection successive d'un jet de gaz dans chacune des buses l'injection 9.

Avantageusement, l'interface 5 comporte plusieurs buses d'injection de gaz 9 configurées pour injecter un jet de gaz pulse L'injection discontinue est alors obtenue par le balayage successif des différentes buses d'injection 9 et/ou par la pulsation du jet de gaz.

L'injection successive à travers les différentes buses d'injection 9 permet d'une part de cibler. l'injection dans certanes zones mortes de l'enveloppe 3 et d'autre part, d'atteindre une importante portion de paroi 13 par le balayage du jet de gaz.

De manière avantageuse, l'unité de tratement peut déterminer une information de la contamination de l'enveloppe 3 relative à chaque buse d'injection 9. Ainsi, l'unité de trairement transmet un signal représentatif de l'état de propreté associé à chaque portion d'enveloppe 3 à analyser, permettant de déterminer des zones plus ou moins sales de l'enveloppe 3.

On distingue sur la figure 4, un exemple avantageux de réalisation de l'interface 5 dans lequel l'interface 5 comporte une pluralité de bases d'injection 9, cinq dans cet exemple.

Les buses 9 peuvent être alignées dans une bande périphérique de la face frontale de l'interface 5, de manière à diriger un jet de gaz perpendiculairement à un plan défini par l'interface 5.

Les dimensions et l'inclinaison des buses d'injection 9 sont adaptées pour générer un jet de gaz perpendiculaire en direction des parois internes 13 de l'enveloppe de l'enceinte 3 permettant de provoquer le décollement des particules 11 adhérées aux parois 13 notamment dans des zones significatives d'un état de pollution de l'enveloppe de l'enceinte de transport 3.

Ainsi, la taille des bases d'injection 9 est relativement faible, par exemple les buses 9 comportent un orifice de l'ordre d'un millimètre de diamètre, de manière à imposer une vitesse élevée au jet de gaz, tout en étant simple à réaliser.

Pour forcer le jet de gaz vers l'intérieur 10 de l'enveloppe 3, la station de mesure 1 comporte avantageusement des obturateurs pour obturer les passages de gaz filtrés de l'enveloppe de l'enceinte de transport 3 (non visibles sur cette figure).

Les obturateurs peuvent par exemple être portés par un plateau 16 de la station de mesure 1. Les obturateurs permettent aussi de s'assurer qu'aucune particule extérieure ne pénètre l'intérieur 10 de l'enveloppe de l'enceinte de transport 3.

Par ailleurs, l'accouplement de l'interface 5 avec l'enveloppe de transport 3 est réalisé de manière non étanche. Pour cela, l'interface 5 est munie d'une pluralité d'entretoises (non représentées), permettant à l'interface 5 de s'accoupler avec l'enveloppe 3 en laissant des interstices pour le passage d'un flux de fuite entre l'intérieur 10 de l'enveloppe 3 et l'environnement extérieur. Les entretoises présentent par exemple la forme de plots régulièrement répartis dans une bande périphérique de la face frontale de l'interface 5.

On prévoit en outre un flux d'injection de gaz supérieur au flux de pompage de sorte que l'intérieur 10 de l'enveloppe de transport 3 soit en légère surpression par rapport à l'environnement extérieur, favorisant ainsi l'écoulement des fluides vers l'extérieur de l'envelopppe 3. Le flux de fuite est alors dirigé à travers les interstices vers l'environnement extérieur. On évite ainsi la contamination en particules de l'intérieur 10 de l'enveloppe 3.

De même, les buses d'injection 9 sont avantageusement pourvues de filtres à particules pour filtrer d'éventuelles particules polluantes provenant de l'environnement extérieur.

On peut aussi prévoir que station de mesure 1 comporte une chambre atmosphérique 27 de type salle blanche, de préférence certifiée Iso. 3, conformément à la norme ISO 14644-1, entourant l'interface 5, de manière à former un mini environnement autour de l'interface 5, renforçant ainsi la propreté de l'injection de gaz.

En fonctionnement, l'unité de traitement est configurée pour traiter et exploiter les résultats de mesure du compteur de particules 19 et pour mettre en oeuvre le procédé de mesure 100.

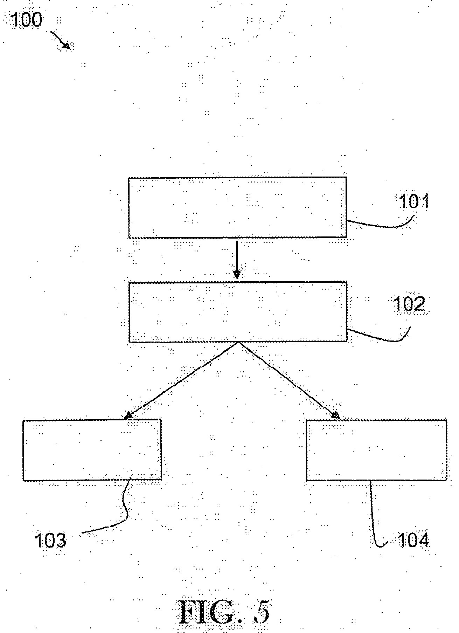

La figure 5 illustre les différentes étapes du procédé de mesure 100. Le procédé de mesure de la contamination en particules 100 est réalisé de préférence avant d'envoyer une enceinte de transport à une unité de nettoyage par un liquide.

Dans une première étape 101, on dirige perpendiculairement un jet de gaz vers une portion de paroi 13 à l'intérieur 10 d'une enveloppe d'une enceinte de transport 3 accouplée à une station de mesure 1 de manière à détacher des particules 11 de l'enveloppe 3 par le jet de gaz.

L'injection du jet de gaz peut être réalisée avant ou après l'accouplement de l'enveloppe"3111i station de mesure 1.

Simultanément, on met la pompe à vide 17 en fonctionnement de manière à produire un écoulement de gaz depuis l'intérieur 10 de l'enveloppe de l'enceinte de transport 3 accouplée à la station de mesure 1 vers le compteur de particules 19.

Le flux d'injection est supérieur au flux de pompage de manière à créer un flux de fuite vers l'extérieur de la station.

On pulse l'injection de gaz et/ou on injecte successivement un jet de gaz dans chacune des buses d'injection 9 et/on on modifie l'orientation et/ou la position de la buse d'injection 9 de manière à balayer une portion de paroi 13 et/ou on injecte une rampe de flux de gaz, au cours de la première étape 101 du procédé de mesure 100 pour obtenir une injection discontinue de gaz.

Ainsi, les particules 11 décollées des parois 13 sont dirigées vers l'entrée 23 du dispositif de mesure 7 pour être détectées par le compteur de pirticules 19.

Au cours d'une deuxième étape 102, on mesure un nombre de particules 11 avec le compteur de particules 19 et on compare le résultat de la mesure à un iseùii prédefini pour déterminer si une étape de nettoyage par un liquide est nécessaire en fonction du résultat issu de la comparaison (étape 103) ou si l'enceinte de transport est suffisament propre pour rester en production et continuer a transporter ou stocker des substrats (étape 104).

On peut également réaliser une succession de mesure sur les parois 13 de manière à mesurer la contamination en particules en différents points.

Pour cela, au cours de la première étape 101, on injecte le jet de gaz perpendiculairement contre la paroi 13, pendant une durée relativement courte comprise entre 5 et 30 secondes,

Puis au cours de la deuxième étape 102, on arrière l'injection et on mesure le nombre de particules. Lorsque la mesure est stabilisée ou lorsque le compteur de particules 19 plus de particules, on déplace la buse d'injection 9 perpendiculairement à une nouvelle portion de paroi. La buse 9 est par exemple déportée axialement, par une translation du tuyau saillant 32, de sorte que l'angle d'injection reste perpendiculaire à la mème paroi 13.

Puis on réitère les premières et deuxièmes étapes 101, 102 afin de déterminer si une étape de nettoyage par un liquide est nécessaire en fonction du résultat issu des comparaisons.

On peut ainsi estimer la contamination pour plusieur points de mesure de la même paroi 13 et pour chaque paroi. On peut également estimer la contamination pour plusieurs points de mesure d'une autre paroi en faisant tourner l'extrémité de la buse 9, de sorte qu'elle soit dirigée perpendiculairement vers une nouvelle paroi 13 de l'enveloppe 3.

Le procédé de mesure 100 permet donc de mesurer en temps réel un niveau de contamination en particules d'enceintes de transport par une succession d'étapes pouvant être implémentées dans une chaine de processus industriel de fabrication.

Par conséquent, il est possible de contrôler rapidement l'état de propreté en particules d'une enceinte de transport. On évite ainsi que des enceintes de transport exemptes de particules soient nettoyées inutilement ou bien que d'autres polluées de particules, continuent à stocker et/ou transporter des substrats de semi-conducteurs.

## Revendications

1. Station de mesure de la contamination en particules d'une enceinte de transport pour le convoyage et le stockage atmosphérique de substrats semi-conducteurs, ladite enceinte comprenant une enveloppe (3) obturable par une porte d'accès amovible, ladite station (1) comportant :
- une interface (5) susceptible de s'accoupler à ladite enveloppe d'enceinte de transport (3), à la place de ladite porte, et
- un dispositif de mesure (7) comportant une pompe à vide (17), un compteur de particules (19) et une canalisation de mesure (21) dont une entrée débouche à l'intérieur (10) de ladite enveloppe (3) et dont une sortie (25) est raccordée à la pompe à vide (17), la canalisation de mesure (21) étant en outre raccordée au compteur de particules (19), pour mettre en communication l'intérieur (10) de l'enveloppe de l'enceinte de transport (3) accouplée à ladite station de mesure (1) avec le compteur de particules (19),
**caractérisée en ce que** l'interface (5) comporte un tuyau saillant (32) et au moins une buse d'injection (9) disposée à une extrémité mobile du tuyau saillant (32) pour diriger un jet de gaz dans une direction perpendiculaire à une portion de paroi (13) à l'intérieur (10) de ladite enveloppe (3) accouplée à ladite station de mesure (1), de manière à détacher des particules (11) de ladite enveloppe (3) par l'impact du jet de gaz sur ladite paroi (13), ladite interface (5) étant munie d'une pluralité d'entretoises permettant à ladite interface (5) de s'accoupler avec ladite enveloppe (3) en laissant des interstices pour le passage d'un flux de fuite entre l'intérieur de ladite enveloppe (3) et l'environnement extérieur.

2. Station de mesure selon la revendication 1, **caractérisé en ce que** lesdites entretoises présentent la forme de plots.

3. Station de mesure selon la revendication 1, comportant une chambre atmosphérique de type salle blanche, de préférence certifiée Iso 3, entourant ladite interface (5).

4. Station de mesure selon l'une des revendications précédentes, dans laquelle la buse d'injection (9) est configurée pour injecter un jet de gaz pulsé.

5. Station de mesure selon l'une des revendications précédentes, dans laquelle l'interface (5) comporte une pluralité de buses d'injection (9) pourvues de filtres à particules.

6. Station de mesure selon l'une des revendications précédentes, comportant des obturateurs destinés à obturer des passages de gaz filtrés de l'enveloppe de l'enceinte de transport (3).

7. Station de mesure selon l'une des revendications précédentes, comportant une unité de traitement pour transmettre un signal représentatif d'un état de propreté de l'enveloppe de ladite enceinte (3) à une unité de nettoyage.

8. Procédé de mesure de la contamination en particules d'une enceinte de transport pour le convoyage et le stockage atmosphérique de substrats semi-conducteurs, comportant :
- une première étape (101) dans laquelle on dirige perpendiculairement un jet de gaz vers une portion de paroi à l'intérieur d'une enveloppe d'une enceinte accouplée à ladite station de mesure de la contamination en particules, telle que définie selon l'une des revendications précédentes, de manière à détacher des particules de l'enveloppe par l'impact du jet de gaz sur ladite paroi et on met la pompe à vide en fonctionnement de manière à produire un écoulement de gaz depuis l'intérieur de l'enveloppe de l'enceinte de transport accouplée à ladite station de mesure vers le compteur de particules,
**caractérisé en ce qu'**au cours de la première étape, le flux d'injection est supérieur au flux de pompage, le procédé de mesure comportant en outre :
- une deuxième étape (102) dans laquelle: on arrête l'injection, on mesure un nombre de particules avec le compteur de particules, on compare le résultat de la mesure à un seuil prédéfini et on déplace la buse d'injection perpendiculairement à une nouvelle portion de paroi, et
- on réitère lesdites premières et deuxièmes étapes (101, 102) pour déterminer si une étape de nettoyage par un liquide est nécessaire en fonction du résultat issu des comparaisons.

9. Procédé de mesure selon la revendication 8, dans lequel on injecte un jet de gaz de façon discontinue, au cours de la première étape (101) dudit procédé de mesure (100).

## Patentansprüche

1. Station zum Messen der Verunreinigung mit Partikeln eines Transportbehälters für die Beförderung und Aufbewahrung in atmosphärischem Kontakt von Halbleitersubstraten, wobei der Behälter eine Umschließung (3) umfasst, die durch eine abnehmbare Zugangstür verschließbar ist, wobei die Station (1) Folgendes umfasst:
- eine Schnittstelle (5), die mit der Umschließung (3) des Transportbehälters anstelle der Tür koppeln kann, und
- eine Messvorrichtung (7), die eine Unterdruckpumpe (17), einen Partikelzähler (19) und eine Messleitung (21), deren Eingang in den Innenraum (10) der Umschließung (3) mündet und deren Ausgang (25) mit der Unterdruckpumpe (17) verbunden ist, aufweist, wobei die Messleitung (21) außerdem mit dem Partikelzähler (19) verbunden ist, um zwischen dem Innenraum (10) der Umschließung des Transportbehälters (3), der mit der Messstation (1) gekoppelt ist, und dem Partikelzähler (19) eine Kommunikation herzustellen,
**dadurch gekennzeichnet, dass** die Schnittstelle (5) ein vorstehendes Rohr (32) und wenigstens eine Einleitungsdüse (9), die an einem beweglichen Ende des vorstehenden Rohrs (32) angeordnet ist, umfasst, um einen Gasstrahl in eine Richtung senkrecht zu einem Wandabschnitt (13) im Innenraum (10) der Umschließung (3), der mit der Messstation (1) gekoppelt ist, zu lenken, derart, dass Partikel (11) der Umschließung (3) durch das Auftreffen des Gasstrahls auf die Wand (13) herausgelöst werden, wobei die Schnittstelle (5) mit mehreren Abstandshaltern versehen ist, die der Schnittstelle (5) ermöglicht, mit der Umschließung (3) zu koppeln und dabei Zwischenräume für den Durchgang eines Leckflusses zwischen dem Innenraum der Umschließung (3) und der äußeren Umgebung zu lassen.

2. Messstation nach Anspruch 1, **dadurch gekennzeichnet, dass** die Abstandshalter die Form von Höckern haben.

3. Messstation nach Anspruch 1, die eine Kammer in atmosphärischem Kontakt des Reinraumtyps, vorzugsweise gemäß ISO 3 zertifiziert, enthält, die die Schnittstelle (5) umgibt.

4. Messstation nach einem der vorhergehenden Ansprüche, wobei die Einleitungsdüse (9) konfiguriert ist, einen gepulsten Gasstrahl einzuleiten.

5. Messstation nach einem der vorhergehenden Ansprüche, wobei die Schnittstelle (5) mehrere Einleitungsdüsen (9) umfasst, die mit Partikelfiltern versehen sind.

6. Messstation nach einem der vorhergehenden Ansprüche, die Verschlüsse umfasst, die dazu bestimmt sind, mit Filtern versehene Gasdurchlässe der Umschließung (3) des Transportbehälters zu verschließen.

7. Messstation nach einem der vorhergehenden Ansprüche, die eine Verarbeitungseinheit umfasst, um ein Signal, das einen Reinheitszustand der Umschließung (3) des Behälters repräsentiert, an eine Reinigungseinheit zu senden.

8. Verfahren zum Messen der Verunreinigung mit Partikeln eines Transportbehälters für die Beförderung und Aufbewahrung in atmosphärischem Kontakt von Halbleitersubstraten, das Folgendes umfasst:
- einen ersten Schritt (101), in dem ein Gasstrahl senkrecht zu einem Wandabschnitt im Innenraum einer Umschließung eines Behälters, der mit der Station zum Messen seiner Verunreinigung mit Partikeln, wie sie in einem der vorhergehenden Ansprüche definiert ist, gekoppelt ist, gelenkt wird, derart, dass Partikel der Umschließung durch das Auftreffen des Gasstrahls auf die Wand ausgelöst werden, und die Unterdruckpumpe betrieben wird, um ein Ausströmen von Gas aus dem Innenraum der Umschließung des Transportbehälters, der mit der Messstation gekoppelt ist, zu dem Partikelzähler zu erzeugen,
**dadurch gekennzeichnet, dass** während des ersten Schrittes der Einleitungsstrom größer als der Pumpstrom ist, wobei das Messverfahren außerdem Folgendes umfasst:
- einen zweiten Schritt (102), in dem: das Einleiten angehalten wird, eine Anzahl von Partikeln mit dem Partikelzähler gemessen wird, das Ergebnis der Messung mit einem im Voraus definierten Schwellenwert verglichen wird und die Einleitungsdüse senkrecht zu einem neuen Wandabschnitt verlagert wird, und
- der erste und der zweite Schritt (101, 102) wiederholt werden, um als Funktion des aus dem Vergleichen stammenden Ergebnisses zu bestimmen, ob ein Schritt des Reinigens mit einer Flüssigkeit erforderlich ist.

9. Messverfahren nach Anspruch 8, wobei ein Gasstrahl während des ersten Schrittes (101) des Messverfahrens (100) auf diskontinuierliche Weise eingeleitet wird.

## Claims

1. Station for measuring the particulate contamination of a transport pod for the atmospheric transportation and storage of semiconductor substrates, the said pod comprising a casing (3) that can be closed by a removable access door, the said station (1) comprising:
- an interface (5) that can be coupled to the said transport pod casing (3), in place of the said door, and
- a measurement device (7) comprising a vacuum pump (17), a particle counter (19) and a measurement pipe (21) an inlet of which opens to the inside (10) of the said casing (3) and an outlet (25) of which is connected to the vacuum pump (17), the measurement pipe (21) also being connected to the particle counter (19) so as to place the inside (10) of the transport pod casing (3), coupled to the said measurement station (1), in communication with the particle counter (19),
**characterized in that** the interface (5) comprises a projecting tube (32) and at least one injection nozzle (9) positioned at a mobile end of the projecting tube (32) so as to direct a jet of gas in a direction perpendicular to a wall portion (13) inside (10) the said casing (3) coupled to the said measurement station (1), so as to detach particles (11) from the said casing (3) by the impingement of the jet of gas onto the said wall (13), the said interface (5) being provided with a plurality of spacers that allow the said interface (5) to couple to the said casing (3) leaving gaps for the passage of a leakage flow between the inside of the said casing (3) and the external environment.

2. Measurement station according to Claim 1, **characterized in that** the said spacers take the form of pads.

3. Measurement station according to Claim 1, comprising an atmospheric chamber of the clean room type, preferably Iso 3 certified, surrounding the said interface (5).

4. Measurement station according to one of the preceding claims, in which the injection nozzle (9) is configured to inject a pulsed gas jet.

5. Measurement station according to one of the preceding claims, in which the interface (5) comprises a plurality of injection nozzles (9) provided with particulate filters.

6. Measurement station according to one of the preceding claims, comprising shutters intended to shut off the filtered gas passages of the transport pod casing (3).

7. Measurement station according to one of the preceding claims, comprising a processing unit for transmitting a signal indicative of a state of cleanliness of the said pod casing (3) to a cleaning unit.

8. Method for measuring the particulate contamination of a transport pod for the atmospheric transportation and storage of semiconductor substrates, comprising:
- a first step (101) in which a jet of gas is aimed at right angles towards a wall portion inside a casing of a pod coupled to the said particulate contamination measurement station, as defined in one of the preceding claims, so as to detach particles from the casing by the impingement of the jet of gas on the said wall and the vacuum pump is switched on so as to cause gas to flow from inside the transport pod casing coupled to the said measurement station towards the particle counter,
**characterized in that**, during the first step, the injection flow is greater than the pumping flow, the measurement method further comprising:
- a second step (102) in which: injection is stopped, a number of particles is measured with the particle counter, the result of the measurement is compared against a predefined threshold and the injection nozzle is moved perpendicular to a new wall portion, and
- the said first and second steps (101, 102) are repeated in order to determine whether a step of cleaning using a liquid is needed according to the result of the comparisons.

9. Measurement method according to Claim 8, in which a jet of gas is injected discontinuously, during the first step (101) of the said measurement method (100).
